(19) Europäisches Patentamt / European Patent Office / Office européen des brevets

(11) **EP 3 457 566 B1**

(12) **FASCICULE DE BREVET EUROPEEN**

(45) Date de publication et mention
de la délivrance du brevet:
**16.02.2022 Bulletin 2022/07**

(21) Numéro de dépôt: **18193347.4**

(22) Date de dépôt: **10.09.2018**

(51) Classification Internationale des Brevets (IPC):
***H03H 11/46*** *(2006.01)*

(52) Classification Coopérative des Brevets (CPC):
**H03H 11/53**

(54) **DISPOSITIF MODIFIANT LA VALEUR D'IMPEDANCE D'UNE RESISTANCE DE REFERENCE**

VORRICHTUNG, DIE DEN IMPEDANZWERT EINES REFERENZWIDERSTANDS ÄNDERT

DEVICE FOR MODIFYING THE IMPEDANCE VALUE OF A REFERENCE RESISTOR

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **13.09.2017 FR 1758491**

(43) Date de publication de la demande:
**20.03.2019 Bulletin 2019/12**

(73) Titulaire: **Commissariat à l'énergie atomique
et aux énergies alternatives
75015 Paris (FR)**

(72) Inventeurs:
• **ROSTAING, Jean-Pierre
38260 LA CÔTE SAINT-ANDRE (FR)**
• **PEIZERAT, Arnaud
38000 GRENOBLE (FR)**

(74) Mandataire: **Brevalex
95, rue d'Amsterdam
75378 Paris Cedex 8 (FR)**

(56) Documents cités:
WO-A1-2016/064380      JP-B2- 2 935 781
US-A1- 2016 020 734      US-A1- 2017 070 209

**Description**

**DOMAINE TECHNIQUE ET ART ANTÉRIEUR**

L'invention concerne un dispositif modifiant la valeur d'impédance d'une résistance de référence et présentant en sortie cette valeur d'impédance modifiée. L'invention est avantageusement utilisée pour former une résistance de haute valeur (RHV) dont l'impédance est par exemple supérieure ou égale à environ 1 MΩ.

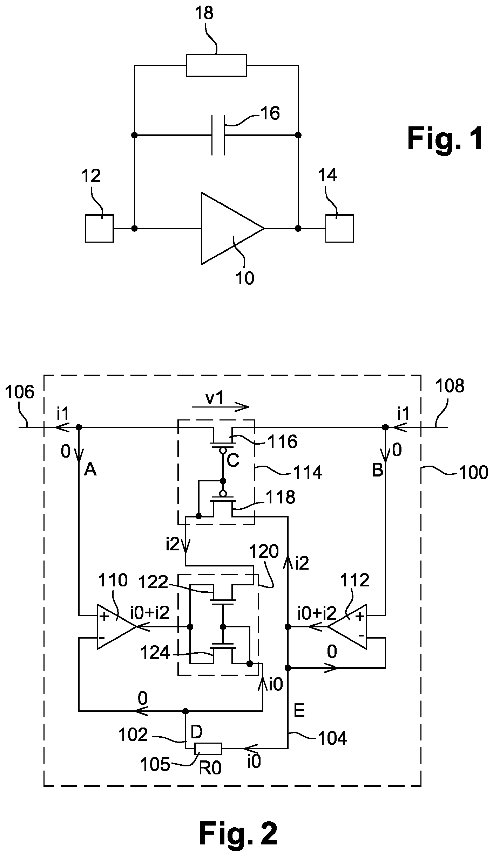

Dans le domaine de la microélectronique, il est parfois nécessaire de disposer d'une RHV à temps continu. C'est le cas avec un amplificateur de charges utilisé par exemple en spectrométrie pour détecter les signaux électriques créés par l'impact des photons dans le détecteur. Un tel amplificateur de charges 10 est représenté sur la figure 1. L'amplificateur de charges 10 comporte une entrée 12 et une sortie 14 auxquelles sont reliées une capacité d'intégration 16 et une RHV 18, en parallèle de l'amplificateur de charges 10. La valeur de l'impédance de la RHV 18 est par exemple de l'ordre de 1 GΩ et celle de la capacité d'intégration 16 de l'ordre de quelques dizaines de femtofarads (fF). La RHV 18 doit présenter une capacité parasite de valeur faible (quelques fF, par exemple moins de 10 fF) et négligeable devant celle de la capacité d'intégration 16, supporter une variation de tension importante (quelques centaines de mV) et présenter une densité de bruit conforme à la physique, soit $\overline{e^2} = 4k_B TR$, avec $k_B$ la constante de Boltzmann égale à $1{,}38{.}10^{-23}\text{J.K}^{-1}$ et T la température en Kelvins.

Or, les impédances obtenues avec des résistances physiques intégrées fabriquées soit en silicium polycristallin haute résistivité, soit sous forme de caisson (« n-well resistor »), ou encore par diffusion, sont de l'ordre de 1 kΩ/carré. Ces résistances forment donc des impédances de valeurs maximales limitées à quelques centaines de kΩ, c'est-à-dire moins de 1 MΩ, car au-delà, les résistances ont une taille trop importante et présentent une capacité parasite trop importante.

Des dispositifs résistifs à temps discret, par exemple à capacités commutées, permettent d'atteindre des valeurs d'impédance élevées. Toutefois, ces dispositifs ne sont pas adaptés pour former des résistances RHV à cause de leur bruit de commutation trop important.

D'autres solutions sont également proposées dans les documents US 6 897 528 B2, US 2013/0069716 A1, US2017/0070209, US2016/0020734 et « Implementing ultra-high-value floating tunable CMOS resistors » de A. Tajalli et al., Electronics Letters, 2008, Volume 44, Issue 5, pages 349-350. Chacune de ces solutions présente toutefois au moins un des inconvénients suivants : la dynamique de tension est trop faible (quelques dizaines de mV au maximum), le bruit équivalent est trop fort, la capacité parasite est trop importante.

D'autres dispositifs électroniques ayant le comportement d'une résistance électrique existent : transistor MOS long, amplificateur à transconductance bouclé, convertisseur d'impédance positive. Mais ces dispositifs ne permettent pas d'obtenir toutes les caractéristiques d'une vraie RHV, à savoir :

- grande valeur de R ;
- densité de bruit de $4k_B TR$ ;
- faible capacité parasite ;
- fonctionnement en fréquence à partir du continu ;
- grande excursion en tension (par exemple de 0,3 V à 1,2 V) ;
- indépendance de la tension (linéarité) ;
- faible sensibilité en température.

**EXPOSÉ DE L'INVENTION**

Un but de la présente invention est de proposer un dispositif modifiant la valeur d'impédance d'une résistance de référence ne présentant pas les inconvénients de l'art antérieur exposés ci-dessus, c'est-à-dire permettant d'atteindre des valeurs d'impédance supérieure ou égale à environ 1 MΩ et pouvant dépasser au moins 1 GΩ, fonctionnant en temps continu et présentant les mêmes propriétés qu'une résistance physique.

Pour cela, la présente invention propose un dispositif électronique selon la revendication 1.

Dans ce dispositif, la valeur d'impédance de la résistance de référence est modifiée grâce au deuxième courant imposé entre les deux deuxièmes bornes et dont la valeur correspond à une fraction de celle du premier courant. Du fait que la tension entre les deux deuxièmes bornes est sensiblement similaire à celle entre les deux premières bornes, la valeur d'impédance présentée entre les deux deuxièmes bornes est bien modifiée par rapport à celle de la résistance de référence. Par exemple, en ayant un premier courant $i_0$ et un deuxième courant $i_1$ dont le rapport des valeurs est $i_1/i_0 = 1/K$, le rapport entre la valeur de l'impédance obtenue entre les deux deuxièmes bornes et celle de la résistance de référence est égal à K.

Le dispositif selon l'invention présente bien les propriétés recherchées, à savoir :

- impédance présentée entre les deux deuxièmes bornes qui peut être de très forte valeur (par exemple supérieure ou à égale à environ 1 GΩ), grâce au facteur multiplicatif appliqué sur la valeur de la résistance de référence,
- bonne linéarité,
- grande dynamique de tension (l'excursion en tension obtenue entre les deux deuxièmes bornes peut approcher la valeur de la tension d'alimentation du dispositif électronique),
- bruit thermique équivalent à celui d'une résistance physique de même valeur,
- capacité parasite très faible (par exemple de l'ordre de 0,5 fF),
- fonctionnement en fréquence à partir d'une tension continue,
- bonne tenue en température,
- sensibilité aux dispersions conforme à celle des composants technologiques utilisés dans le dispositif électronique (par exemple : transistors MOS, résistances),
- bruit en 1/f dû par exemple aux transistors MOS du dispositif,
- surface occupée de l'ordre de quelques centaines de $\mu m^2$ (par exemple moins de 1 $mm^2$),
- consommation égale à quelques dizaines de $\mu W$ (par exemple moins de 100 $\mu W$).

Un deuxième courant de valeur i1 correspondant à une fraction de la valeur i0 d'un premier courant sont tels que leurs valeurs respectent la relation i1/i0 < 1.

Le deuxième circuit du dispositif selon la revendication 1 comporte un premier transistor FET dont la source et le drain sont chacun reliés à l'une des deux deuxièmes bornes et dont la grille est apte à, ou configurée pour, recevoir un potentiel électrique issu du deuxième circuit et dont la valeur dépend de celle du premier courant. La valeur du potentiel électrique appliqué sur la grille du premier transistor FET peut être contrôlée par le courant circulant à travers la résistance de référence. La valeur du courant circulant à travers le premier transistor FET (courant drain-source) étant contrôlée par la valeur du potentiel appliqué sur la grille du premier transistor FET, ce courant circulant à travers le premier transistor FET a donc une valeur proportionnelle à celle du courant circulant à travers la résistance de référence.

Le deuxième circuit du dispositif selon la revendication 1 utilise judicieusement la propriété des miroirs de courant à recopier un courant en appliquant un facteur de multiplication ou de division sur la valeur de ce courant, ce facteur étant défini par le rapport des dimensions des canaux des transistors du miroir de courant. En dimensionnant de manière différente les transistors FET d'au moins un des premier et deuxième miroirs de courant, un facteur de multiplication ou de division défini par le rapport des dimensions différentes des canaux de ce ou ces miroirs de courant est donc appliqué sur le premier courant, ce qui définit la valeur du deuxième courant.

En multipliant le nombre de miroirs de courant utilisés pour former le deuxième circuit, un facteur de multiplication K (entre la valeur d'impédance de la résistance de référence et celle présentée par le dispositif entre les deux deuxièmes bornes) important peut être facilement obtenu sans occuper une surface importante.

Quel que soit le nombre de miroirs de courant formant le deuxième circuit, ces miroirs peuvent être reliés électriquement entre eux en série afin que les facteur de multiplication ou de division sur la valeur du courant traversant ces miroirs de courant se cumulent. Cela peut s'appliquer à tous les modes de réalisation décrits.

En outre, le dispositif peut être tel que :

- le drain du quatrième transistor FET soit relié à l'une des deux premières bornes ;
- le drain du troisième transistor FET soit relié au drain du deuxième transistor FET ;
- la source du deuxième transistor FET soit reliée à l'autre des deux premières bornes.

Le deuxième circuit peut comporter en outre au moins un troisième miroir de courant interposé entre le drain du troisième transistor FET et le drain du deuxième transistor FET. Ainsi, un facteur de multiplication ou de division supplémentaire, défini par le rapport des dimensions des canaux des transistors FET de ce troisième miroir de courant, vient s'ajouter à ceux des premier et deuxième miroirs de courant.

En outre, le dispositif peut être tel que revendiqué aux revendications dépendants.

Le dispositif peut comporter un quatrième circuit apte à, ou configuré pour, modifier le rapport des dimensions des canaux des transistors d'au moins un des miroirs de courant. Un tel quatrième circuit peut par exemple comporter des interrupteurs permettant de choisir parmi plusieurs transistors de dimensions différentes ceux qui formeront le miroir de courant.

Le dispositif peut comporter en outre au moins deux résistances formant un pont diviseur de tension, la résistance de référence étant reliée en parallèle à l'une des deux résistances du pont diviseur de tension. Ainsi, le rapport de multiplication K entre la valeur d'impédance de la résistance de référence et celle présentée par le dispositif entre les deux deuxièmes bornes est aisément augmenté grâce au pont diviseur de tension.

L'invention concerne également un circuit électronique tel que revendiqué aux revendications 11 et 12.

## BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :

- la figure 1 représente un amplificateur de charges couplé à une résistance RHV ;
- les figures 2-8 représentent plusieurs modes et variantes de réalisation d'un dispositif électronique objet de la présente invention ;
- la figure 9 représente un miroir de courant ayant l'un de ses transistors à largeur variable ;
- les figures 10 à 13 représentent des résultats de simulation obtenus à partir d'un dispositif électronique objet de la présente invention ;
- la figure 14 représente un circuit électronique comprenant un dispositif de modification de valeur d'impédance d'une résistance de référence selon l'invention.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

## EXPOSÉ DÉTAILLÉ DE MODES DE RÉALISATION PARTICULIERS

La figure 2 représente un dispositif électronique 100 selon un premier mode de réalisation, permettant de modifier la valeur d'impédance d'une résistance de référence 105.

Le dispositif 100 comporte deux premières bornes 102, 104 auxquelles la résistance de référence 105 est reliée. Un potentiel électrique $V_D$ est destiné à être obtenu sur la borne 102 et un potentiel électrique $V_E$ est destiné à être obtenu sur la borne 104. La résistance de référence 105 a une impédance de valeur $R_0$ et est destinée à être traversée par un courant $i_0$ en raison d'une tension $V_{DE}$ appliquée entre les deux première bornes 102, 104 et à laquelle la résistance de référence 105 est soumise.

Le dispositif 100 comporte également deux deuxièmes bornes 106, 108 entre lesquelles une valeur modifiée de l'impédance de la résistance de référence 105 est destinée à être obtenue. Un potentiel électrique $V_A$ est destiné à être obtenu sur la borne 106 et un potentiel électrique $V_B$ est destiné à être obtenu sur la borne 108. Le dispositif 100 est destiné à être traversé, via les deuxièmes bornes 106, 108, par un courant $i_1$.

Le dispositif 100 comporte un premier amplificateur opérationnel 110 comportant son entrée non inverseuse reliée à la borne 106, et donc au potentiel électrique $V_A$, et son entrée inverseuse reliée à la borne 102 et donc au potentiel électrique $V_D$.

Le dispositif 100 comporte un deuxième amplificateur opérationnel 112 comportant son entrée non inverseuse reliée à la borne 108, et donc au potentiel électrique $V_B$, et son entrée inverseuse reliée à la borne 104 et donc au potentiel électrique $V_E$.

La sortie du deuxième amplificateur opérationnel 112 est reliée directement à son entrée inverseuse, formant ainsi un montage suiveur, ainsi qu'à l'entrée d'un premier miroir de courant 114 formé d'un premier transistor FET 116 et d'un deuxième transistor FET 118. Ce premier miroir de courant délivre le courant $i_1$. Les premier et deuxième transistors FET 116, 118 sont ici de type P.

La sortie du premier amplificateur opérationnel 110 est reliée à un deuxième miroir de courant 120 destiné à recevoir en entrée le courant $i_0$ et à délivrer un courant $i_2$ dont la valeur est fonction du rapport des dimensions de troisième et quatrième transistors FET 122, 124 formant le deuxième miroir de courant 120. Les troisième et quatrième transistors FET 122, 124 sont de type opposé à celui des premier et deuxième transistors FET 116, 118, c'est-à-dire ici de type N.

Le premier amplificateur opérationnel 110 comporte sa sortie reliée aux sources des troisième et quatrième transistors FET 122, 124, fournissant la somme des courants $i_0$ et $i_2$ aux sources des troisième et quatrième transistors FET 122, 124.

Le drain du quatrième transistor FET 124 est relié à la borne 102 ainsi qu'aux grilles des troisième et quatrième transistors FET 122, 124. Le drain du troisième transistor FET 122 est relié au drain du deuxième transistor FET 118, reliant ainsi entre eux les premier et deuxième miroirs de courant 114, 120. Les premier et deuxième miroirs de courant 114, 120 peuvent être vus comme étant reliés en série l'un à l'autre. Le drain du deuxième transistor FET 118 est relié aux grilles des premier et deuxième transistors FET 116, 118. Le drain du premier transistor FET 116 est relié à la borne 106 et la source du premier transistor FET 116 est reliée à la borne 108.

Au sein du dispositif 100, les amplificateurs opérationnels 110, 112 forment un premier circuit configuré pour appliquer entre les deux deuxièmes bornes 106, 108 une tension sensiblement égale à celle se trouvant entre les deux premières bornes 102, 104. Le premier amplificateur opérationnel 110 assure l'égalité des valeurs des potentiels électriques $V_A$ et $V_D$. De même, le deuxième amplificateur opérationnel 112 assure l'égalité des valeurs des potentiels électriques $V_B$ et $V_E$. Ce premier circuit permet donc d'avoir :

$$V_{AB} = V_{DE} = R_0.i_0 \qquad (1)$$

avec $R_0.i_0$ correspondant à la tension aux bornes de la résistance de référence 105.

Le dispositif 100 représenté sur la figure 2 est adapté pour fonctionner avec $V_B > V_A$. Dans ce cas, les miroirs de courants 114 et 120 sont tels que les premier et deuxième transistors 116, 118 formant le premier miroir de courant 114 sont de type P, et que les troisième et quatrième transistors 122, 124 formant le deuxième miroir de courant 120 sont de type N.

Les miroirs de courant 114, 120 forment ensemble un deuxième circuit configuré pour faire circuler entre les deux deuxièmes bornes 106, 108 le courant $i_1$ dont la valeur correspond à une fraction (ou éventuellement un multiple) du courant $i_0$. En effet, les valeurs des courants $i_0$, $i_2$ et $i_1$ sont liées entre elles par les rapports des dimensions des transistors FET formant chacun des miroirs de courants 114, 120. Ainsi, la relation liant les valeurs des courants $i_0$ et $i_2$ est :

$$i_0 = k_2.i_2 \text{ avec } k_2 = (W_{124}/W_{122}).(L_{122}/L_{124}) \qquad (2)$$

avec $W_{122}$ la largeur de canal du troisième transistor 122, $W_{124}$ la largeur de canal du quatrième transistor 124, $L_{122}$ la longueur de canal du troisième transistor 122, et $L_{124}$ la longueur de canal du quatrième transistor 124.

En réalisant les troisième et quatrième transistors 122, 124 avec des canaux de longueurs égales l'une de l'autre, la relation (2) reliant les valeurs des courants $i_0$ et $i_2$ devient alors :

$$i_0 = k_2.i_2 = (W_{124}/W_{122}).i_2 \qquad (3).$$

En outre, la relation liant les valeurs des courants $i_2$ et $i_1$ est :

$$i_2 = k_1.i_1, \text{ et } k_1 = (W_{118}/W_{116}).(L_{116}/L_{118}) \qquad (4)$$

avec $W_{116}$ la largeur de canal du premier transistor 116, $W_{118}$ la largeur de canal du deuxième transistor 118, $L_{116}$ la longueur de canal du premier transistor 116, et $L_{118}$ la longueur de canal du deuxième transistor 118.

En réalisant les premier et deuxième transistors 116, 118 avec des canaux de longueurs égales l'une de l'autre, la relation (4) entre les courants $i_2$ et $i_1$ devient alors :

$$i_2 = k_1.i_1 = (W_{118}/W_{116}).i_1 \qquad (5).$$

Ainsi, avec des transistors 116, 118, 122 et 124 ayant tous des canaux de même longueur, la relation entre les courants $i_0$ et $i_1$ est donc :

$$i_0 = k_1.k_2.i_1 = (W_{118}/W_{116}). (W_{124}/W_{122}).i_1 = K.i_1 \qquad (6).$$

Avec $V_1$ la tension entre la source et le drain du premier transistor 116 et $i_1$ le courant circulant entre les deuxièmes bornes 106 et 108, la résistance $R_{AB}$ est telle que :

$$R_{AB} = V_1/i_1 = V_{AB}/i_1 \qquad (7).$$

Du fait que le potentiel $V_A$ est égal au potentiel $V_D$ et que le potentiel $V_B$ est égal au potentiel $V_E$, et en considérant les équations (6) et (7) ci-dessus, $R_{AB}$ est telle que :

$$R_{AB} = V_{ED}.K/i_0 = K.R_0 \hspace{4cm} (8).$$

Ainsi, le dispositif 100 permet de présenter entre les deux deuxièmes bornes 106, 108 une impédance de valeur égale à celle de la résistance $R_0$ multipliée par le facteur K.

De manière avantageuse, en choisissant une résistance de référence 105 ayant une impédance élevée, par exemple égale à 100 k$\Omega$, et en dimensionnant les canaux des transistors FET des miroirs de courant 114, 120 tels que $k_1 = k_2 = 100$, le dispositif 100 permet de former une résistance RHV dont l'impédance est par exemple $R_0 = 1$ G$\Omega$.

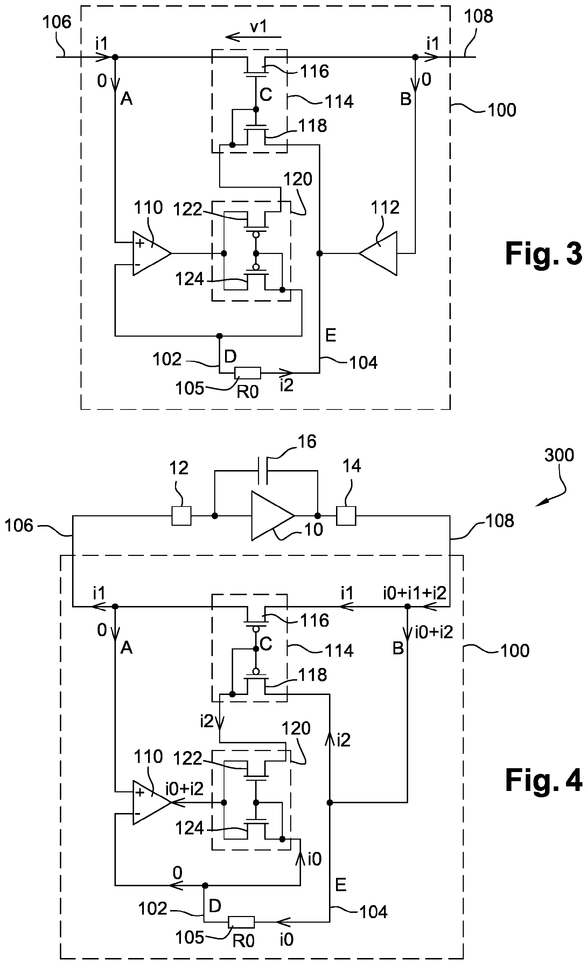

La figure 3 représente un dispositif 100 de modification d'impédance selon un deuxième mode de réalisation.

Le dispositif 100 selon ce deuxième mode de réalisation comporte les mêmes éléments que ceux du dispositif 100 selon le premier mode de réalisation représenté sur la figure 2, c'est-à-dire les amplificateurs opérationnels 110, 112 (sur la figure 3, une seule entrée de l'amplificateur 112 qui monté en suiveur est représentée, cette unique entrée correspondant à l'entrée non inverseuse de l'amplificateur opérationnel 112) et les miroirs de courant 114, 120 formés des transistors FET 116, 118, 122 et 124. A la différence du premier mode de réalisation, les transistors FET 116, 118 sont ici de type N et les transistors FET 122, 124 sont de type P. En inversant ainsi la polarité des transistors FET, le dispositif 100 représenté sur la figure 3 est adapté pour fonctionner avec $V_B < V_A$. Le fonctionnement de ce dispositif 100 est analogue à celui précédemment décrit en lien avec la figure 2.

Selon un autre mode de réalisation, afin d'avoir un dispositif de modification de la valeur d'impédance de la résistance de référence 105 fonctionnant indépendamment des valeurs des potentiels électriques $V_A$ et $V_B$ (c'est-à-dire aussi bien avec $V_A < V_B$ qu'avec $V_A > V_B$), il est possible de relier entre eux les composants de deux dispositifs 100 de polarités opposés (l'un correspondant à celui représenté sur la figure 2 et l'autre correspondant à celui représenté sur la figure 3) aux niveau de leurs bornes 106, 108. Ainsi, suivant le signe de la tension $V_{AB}$, les composants de l'un ou l'autre des deux dispositifs 100 permettent l'obtention de la valeur d'impédance modifiée entre les bornes 106, 108. Un tel dispositif peut être muni d'interrupteurs connectant les composants de l'un ou l'autre des deux dispositifs 100 aux bornes 106, 108 suivant le signe de la tension $V_{AB}$.

Selon un autre mode de réalisation permettant d'avoir un dispositif de modification de la valeur d'impédance de la résistance de référence 105 fonctionnant indépendamment des valeurs des potentiels électriques $V_A$ et $V_B$, ce dispositif peut correspondre à l'un des deux dispositifs 100 représentés sur les figures 2 et 3, et comporter en outre deux autres miroirs de courant complémentaires des miroirs de courant 114, 120. Le dispositif 100 comporte également dans ce cas des commutateurs permettant de relier les bornes 106, 108, les amplificateurs opérationnels 110, 112 et la résistance de référence 105 soit aux miroirs de courant 114, 120, soit aux miroirs de courant complémentaires selon le signe de la tension $V_{AB}$. Les commutateurs d'un tel dispositif 100 permettent de passer de la configuration représentée sur la figure 2 à celle représentée sur la figure 3 sans avoir à dupliquer tous les composants du dispositif 100.

Dans certains cas, par exemple si le dispositif 100 est relié en contre-réaction d'un amplificateur de charges, la sortie à basse impédance de l'amplificateur de charges est alors à même de fournir le courant $i_0 + i_2$ nécessaire au fonctionnement du dispositif 100. Dans ce cas, le dispositif 100 peut ne pas comporter l'amplificateur opérationnel 112, avec alors la résistance de référence 105 reliée directement aux drains des transistors FET 116, 118 du premier miroir de courant 114. La figure 4 représente un circuit électronique 300 comportant le dispositif 100 selon un troisième mode de réalisation qui correspond à la configuration décrite ci-dessus, c'est-à-dire relié en contre-réaction de l'amplificateur de charges 10 (ici dans une configuration similaire à celle décrite précédemment en lien avec la figure 1). La borne 104 est reliée directement aux drains des transistors FET 116, 118 du premier miroir de courant 114 ainsi qu'à la borne 108.

En outre, dans la configuration représentée sur la figure 4, les potentiels électriques $V_B$ et $V_A$ sont en permanence tels que $V_B > V_A$. Ainsi, l'ajout de composants supplémentaires pour assurer le fonctionnement du dispositif 100 lorsque $V_B < V_A$ n'est pas nécessaire.

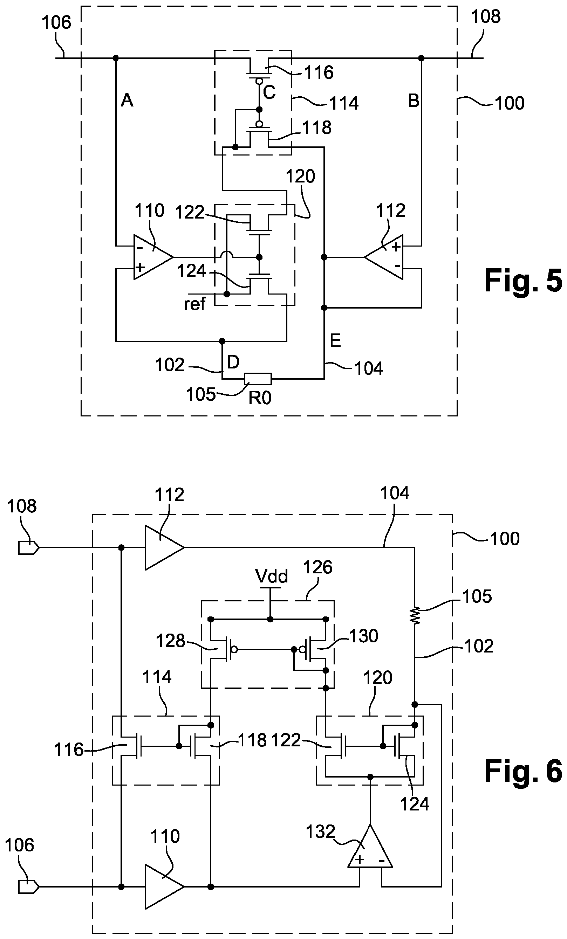

La figure 5 représente le dispositif 100 de modification d'impédance selon un quatrième mode de réalisation.

Ce dispositif 100 comporte les mêmes composants que ceux du dispositif 100 selon le premier mode de réalisation. Par contre, dans ce quatrième mode de réalisation :

- le drain du quatrième transistor FET 124 est déconnecté des grilles des troisième et quatrième transistors FET 122, 124 ;
- les sources des transistors FET 122, 124 du deuxième miroir de courant 120 ne sont pas reliées à la sortie de l'amplificateur opérationnel 110 mais sont reliées à un potentiel électrique de référence, qui peut correspondre par exemple au potentiel d'alimentation ou à la masse du dispositif 100 ;
- la sortie de l'amplificateur opérationnel 110 est reliée aux grilles des transistors FET 122, 124 du deuxième miroir de courant 120 ;
- les connexions aux entrées de l'amplificateur opérationnel 110 sont permutées (par rapport à la configuration selon le premier mode de réalisation) afin d'assurer la phase de contre-réaction.

Par rapport au premier mode de réalisation, ce dispositif 100 selon ce quatrième mode de réalisation a pour avantage d'avoir une dynamique de fonctionnement un peu plus importante.

Ces différences entre les quatrième et premier modes de réalisation peuvent également être appliquées pour le deuxième mode de réalisation, c'est-à-dire au cas où les transistors FET 122, 124 sont de type P et les transistors FET 116, 118 sont de type N.

Dans les précédents modes de réalisation, le dispositif 100 comporte un nombre pair de miroirs de courant. Selon un autre mode de réalisation, le dispositif 100 peut comporter un nombre impair de miroirs de courant. Dans ce cas, par rapport aux dispositifs 100 précédemment décrits comportant deux miroirs de courant, le dispositif 100 comporte au moins un amplificateur supplémentaire monté en suiveur. Le dispositif 100 représenté sur la figure 6 correspond à un tel mode de réalisation, appelé cinquième mode de réalisation.

Sur la figure 6, le dispositif 100 comporte, en plus des deux miroirs de courant 114, 120 (qui comportent ici tous les deux des transistors FET de type N), un troisième miroir de courant 126 formé de deux transistors FET 128, 130, ici de type P. Ce troisième miroir de courant 126 est interposé entre les deux miroirs de courant 114, 120, le drain de chacun des transistors FET 128, 130 étant relié à l'un des deux miroirs de courants 114, 120. Dans cette configuration, les miroirs de courant 114, 120, 126 peuvent être vus comme étant reliés électriquement entre eux en série. Les sources des transistors FET 128, 130 du troisième miroir de courant 126 sont ici reliées directement au potentiel d'alimentation Vdd du dispositif 100. En outre, ce dispositif 100 comporte un amplificateur opérationnel 132 supplémentaire monté en suiveur et interposé entre l'amplificateur 110 et le miroir de courant 120.

Dans la configuration représentée sur la figure 6, le rapport de dimensions des transistors FET 128, 130 du miroir de courant 126 vient se cumuler à ceux des transistors des miroirs de courant 114, 120, augmentant ainsi le rapport de transformation d'impédance réalisée par le dispositif 100. Dans l'exemple de réalisation représenté sur la figure 6, le rapport de dimensions des transistors de chacun des miroirs de courant 114, 120, 126 est égal à 10, ce qui permet d'obtenir entre les bornes 106 et 108 une résistance $R_{AB} = 10^3 R_0$. Par exemple, avec une résistance de référence 105 de valeur $R_0 = 100$ kΩ, l'impédance obtenue avec le dispositif 100 est $R_{AB} = 100$ MΩ.

Selon une alternative, les types N ou P des transistors des miroirs de courant 114, 120, 126 peuvent être inversés par rapport à la configuration décrite ci-dessus.

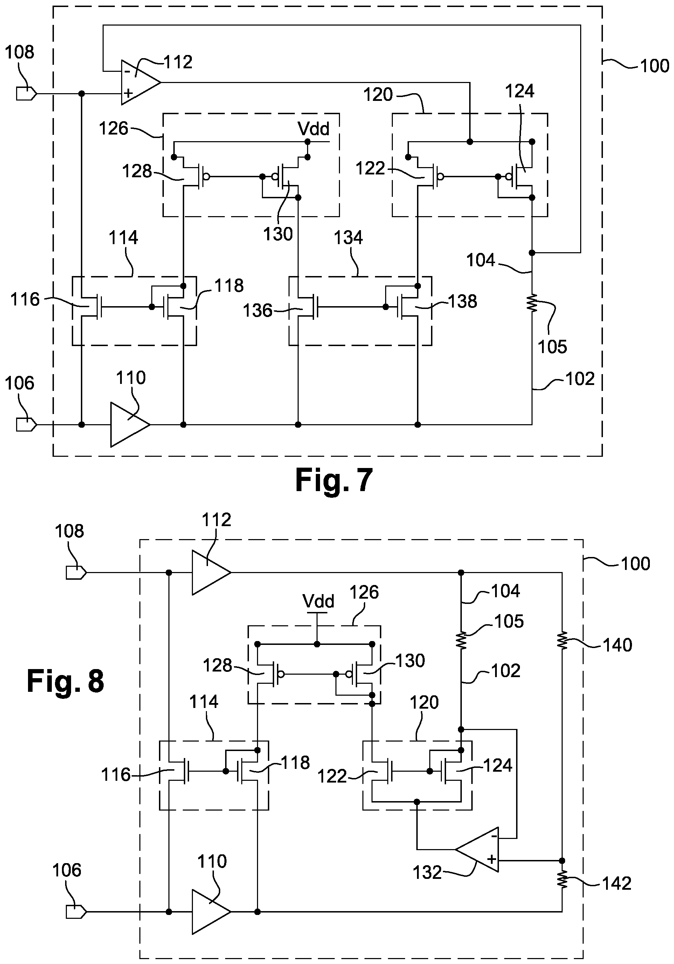

Que le dispositif 100 comporte un nombre de miroirs de courant pair ou impair, le dispositif 100 peut comporter plus de 2 ou 3 miroirs de courant. En effet, un nombre plus important de miroirs de courant permet soit d'augmenter le facteur de multiplication de la valeur d'impédance par le dispositif 100, soit, pour un facteur de multiplication donné, de réduire les dimensions globales des miroirs de courant en réduisant les dimensions et/ou le nombre de transistors FET au sein des miroirs de courant. Le dispositif 100 représenté sur la figure 7 correspond à un tel mode de réalisation, appelé sixième mode de réalisation.

Sur la figure 7, le dispositif 100 comporte quatre miroirs de courants 114, 120, 126, 134, deux des quatre miroirs de courant 120, 126 comprenant des transistors FET de type P 122, 124, 128, 130, les deux autres miroirs de courant 114, 134 comprenant des transistors FET de type N 116, 118, 136, 138. Les miroirs de courants 114, 120, 126, 134 sont reliés électriquement entre eux tels que les rapports de dimensions des transistors des miroirs de courants 114, 120, 126, 134 se cumulent et permettent ainsi l'obtention d'un plus grand facteur de multiplication de la valeur $R_0$ de la résistance de référence 105 ou bien une réduction des dimensions des miroirs de courant pour un facteur de multiplication donné. Les sources des transistors FET 128, 130 du miroir de courant 126 sont reliées électriquement au potentiel électrique d'alimentation Vdd du dispositif 100.

A titre d'exemple, en réalisant chacun des miroirs de courants tels que le rapport des largeurs des transistors de chacun des miroirs de courant soit égal 10, il est possible d'obtenir, à partir d'une résistance de référence 105 avec $R_0 = 100$ kΩ, une impédance $R_{AB} = 1$ GΩ grâce au facteur multiplicatif K = 10000 obtenu. Par rapport à un dispositif 100 présentant le même facteur multiplicatif K mais réalisé avec uniquement deux miroirs de courant, la taille occupée par les quatre miroirs de courant de ce dispositif 100 est environ 5 fois inférieure à celle occupée par deux miroirs de courant.

Un dispositif 100 selon un septième mode de réalisation est représenté sur la figure 8. Ce dispositif 100 comporte tous les éléments précédemment décrits en lien avec le dispositif 100 de la figure 6, c'est-à-dire les trois miroirs de courant 114, 120, 126 et les trois amplificateurs 110, 112, 132. En plus de ces éléments, le dispositif 100 selon ce septième mode de réalisation comporte deux résistances 140, 142 formant un pont diviseur de tension, permettant de modifier la valeur de la tension appliquée aux bornes de la résistance de référence 105. Sur la figure 8, la consigne appliquée sur l'entrée positive de l'amplificateur 132 correspond à une fraction de la tension $V_{AB}$. Ainsi, la tension $V_{ED}$ appliquée aux bornes de la résistance de référence 105 est :

$$V_{ED} = (V_B - V_A).R_{140}/(R_{140} + R_{142}) \qquad (9)$$

avec $R_{140}$ la valeur d'impédance de la résistance 140 et $R_{142}$ la valeur d'impédance de la résistance 142.

Ainsi, le courant $i_0$ se trouve donc réduit dans la proportion $R_{140}/(R_{140}+R_{142})$ et la résistance $R_{AB}$ est ainsi augmenté du rapport $(R_{140}+R_{142})/R_{140}$.

A titre d'exemple, la valeur de la résistance $R_{140}$ peut être égale à 50 k$\Omega$ et celle de la résistance $R_{142}$ peut être égale à 150 k$\Omega$. Ainsi, la résistance $R_{AB}$ est augmentée d'un facteur 4, et passant par exemple de la valeur 100 M$\Omega$ à 400 M$\Omega$.

La valeur de la résistance $R_{AB}$ peut également être modifiée par d'autres moyens. Par exemple, il est possible que le dispositif 100 comporte des interrupteurs (par exemple formés par des transistors) permettant de relier une ou plusieurs résistances supplémentaires en série ou en parallèle de la résistance de référence 105. Il est également possible d'avoir des interrupteurs permettant de choisir, parmi plusieurs résistances de référence de valeurs différentes, celle qui sera reliée aux autres éléments du dispositif 100.

De tels interrupteurs peuvent également servir pour connecter, au sein des miroirs de courant, différents transistors de type N ou P, ce qui permet de relier ou non ces transistors entre eux pour former les miroirs de courants. Avec des transistors de largeurs différentes, il est ainsi possible de modifier la valeur du rapport entre les courants traversant les miroirs de courant, ce qui change le facteur de multiplication d'impédance, en fonction des signaux de commande reçus par les interrupteurs.

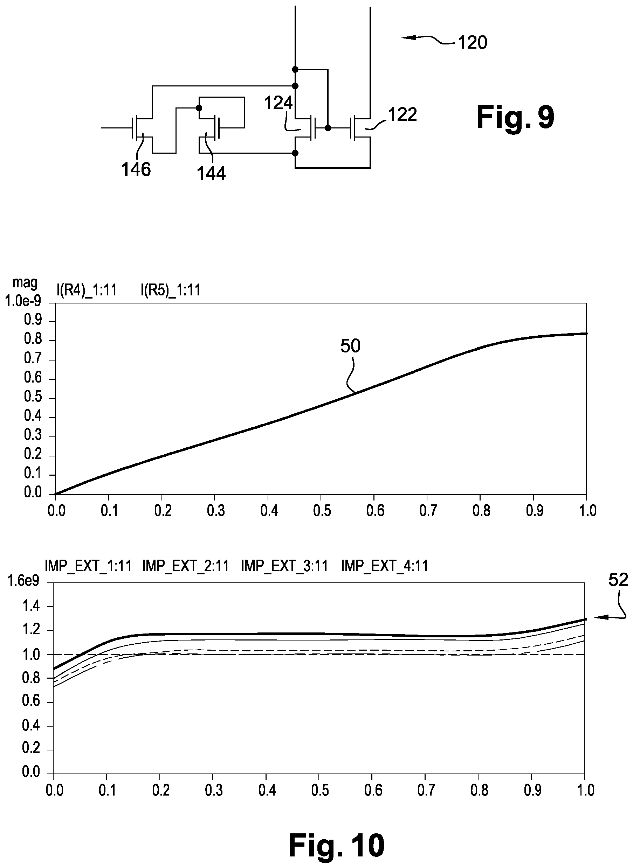

Il est également possible, pour un ou plusieurs des miroirs de courant du dispositif 100, d'avoir un ou plusieurs transistors disposés en parallèle de ce miroir de courant et dont la connexion avec le miroir de courant est commandée par un interrupteur. La figure 9 représente par exemple le miroir de courant 120 comportant un transistor 144 pouvant être relié ou non en parallèle du transistor 124 en fonction de l'état passant ou bloqué d'un transistor de commande 146. Lorsque le transistor 144 est relié en parallèle au transistor 124, les largeurs des transistors 144 et 124 s'additionnent, modifiant ainsi le rapport entre les courants circulant dans les deux branches du miroir de courant 120.

En outre, la grille du transistor 116, dont les source et drain sont reliés aux bornes 106 et 108, peut être reliée à des grilles d'autres transistors FET homothétiques du transistor 116 et dont les drains sont reliés à la borne 108 et dont les sources sont reliées à un nœud porté au même potentiel $V_A$.

Les performances obtenues avec un dispositif 100 similaire à celui représenté sur la figure 3 sont décrites ci-dessous. Ce dispositif 100 est réalisé en technologie CMOS 130 nm et alimenté avec une tension de +1,2 V. La résistance de référence 105 utilisée a pour valeur $R_0$ = 100 k$\Omega$ et les transistors 116, 118, 122 et 124 sont dimensionnés tels qu'au sein de chacun des miroirs de courant 114, 120, le rapport de dimensions entre les transistors soit égal à 100, ce qui permet au dispositif 100 d'avoir un facteur multiplicatif de la valeur $R_0$ égal à 10000. La valeur nominale de la résistance $R_{AB}$ obtenue entre les bornes 106 et 108 est donc égale à 1 G$\Omega$.

La courbe 50 visible sur la figure 10 représente le courant nominal $i_1$ obtenu en fonction de la valeur de la tension $V_{AB}$. Les courbes 52 représentent l'impédance $R_{AB}$ obtenue par simulation Monte Carlo. Ces simulations sont réalisées en courant continu. Ces courbes montrent que la valeur nominale de la résistance $R_{AB}$ est tenue entre environ $V_{AB}$ = 0,1 V et $V_{AB}$ = 0,9 V. Les variations obtenues sur la simulation Monte Carlo par rapport à la valeur nominale, de l'ordre de 20 %, sont liées aux dispersions des composants (transistors FET et résistance de référence 105).

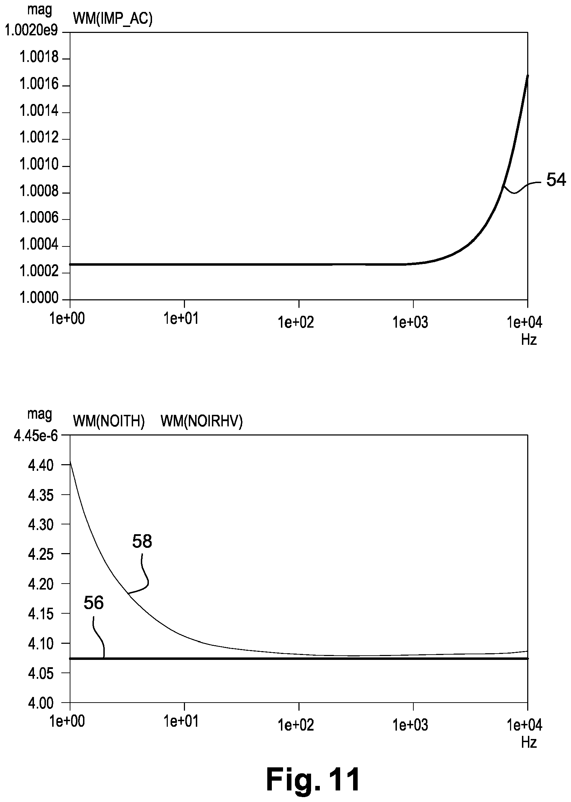

Les courbes 54, 56 et 58 visibles sur la figure 11 sont le résultat d'une simulation en courant alternatif de 1 Hz à 1 kHz à T = 300 K. La courbe 54 correspond à l'impédance obtenue à un point de fonctionnement choisi tel que $R_{AB}$ = 1002 M$\Omega$. La courbe 56 représente la densité de bruit théorique d'une résistance de 1 G$\Omega$, soit 4,07 $\mu$V/HZ$^{1/2}$. La courbe 58 représente la densité de bruit obtenue avec la résistance $R_{AB}$, qui est de 4,08 $\mu$V/Hz$^{1/2}$, ce qui est très proche de la valeur théorique. La courbe 58 montre qu'une montée du bruit en basse fréquence est obtenue, en raison du bruit en 1/f des transistors FET.

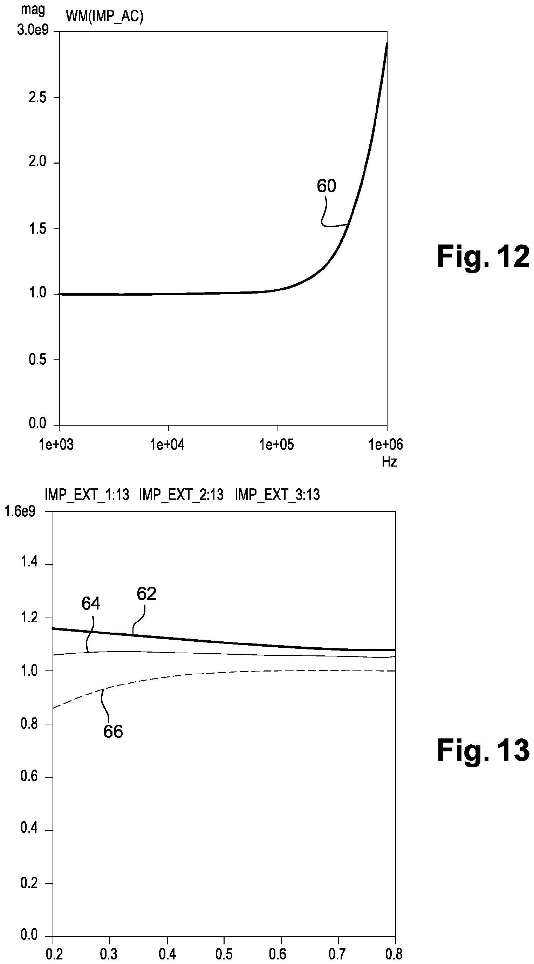

La courbe 60 visible sur la figure 12 représente l'impédance du dispositif 100 entre 1 kHz et 1 MHz. Cette courbe 60 montre une fréquence de coupure à -3dB à 400 kHz provoquée par les pôles internes du dispositif 100 et due à l'effet des capacités des transistors FET et de la résistance de référence 105. Vu de la résistance $R_{AB}$, la capacité parasite Cp en fonction de la fréquence frq est donc Cp = $1/(2\pi R_{AB}frq)$ = 0,4 fF, ce qui est une valeur acceptable dans une utilisation du dispositif 100 en tant que RHV comme représentée sur la figure 1.

Les courbes 62, 64 et 66 visibles sur la figure 13 représentent les variations de la résistance $R_{AB}$ obtenues en fonction de la température (courbe 62 : 50°C ; courbe 64 : 27 °C ; courbe 66 : 0 °C), et en fonction de la valeur de la tension $V_{AB}$. Ces variations sont inférieures à +/- 20% dans la gamme de tension 0,2 V - 0,8 V, et sont liées aux dérives des composants du dispositif 100. Ces variations peuvent être réduites en choisissant des composants présentant peu de dérive par rapport à la température, et/ou en réalisation une compensation de ces variations.

Les transistors du dispositif 100 sont de type FET, par exemple des MOSFET ou des JFET.

Dans chacun des miroirs de courant du dispositif 100, l'égalité entre les tensions grille - source des transistors FET du miroir de courant peut être obtenue grâce à des liaisons physiques (grilles des transistors reliées électriquement entre elles et sources des transistors reliées électriquement entre elles) ou bien par report de potentiels (masse virtuelle).

En outre, les miroirs de courant du dispositif 100 peuvent comporter deux transistors comme dans les modes de réalisation précédemment décrits, ou bien un plus grand nombre de transistors, par exemple 3 ou 4 transistors (montage cascode, Wilson, etc.) voire plus, ce qui permet d'améliorer les caractéristiques et la zone de fonctionnement des miroirs de courant, en particulier lors d'un fonctionnement sous une tension très faible.

De manière avantageuse, la réalisation de transistors FET de largeurs différentes pour former un miroir de courant peut consister à réaliser un transistor élémentaire de canal de dimensions W/L, par exemple W/L = 1 $\mu$m / 1 $\mu$m, et de répéter ce transistor élémentaire plusieurs fois pour former un transistor ayant un canal de plus grande largeur. Par exemple, pour former un miroir de courant comprenant deux transistors FET dont le rapport de largeur des canaux est égal à 100, il est possible de réaliser une matrice de 101 transistors FET élémentaires, 100 de ces transistors servant à former ensemble un premier des deux transistors du miroir de courant, et le dernier transistor élémentaire (avantageusement disposé au centre de la matrice pour minimiser les dispersions technologiques) formant le deuxième des deux transistors du miroir de courant.

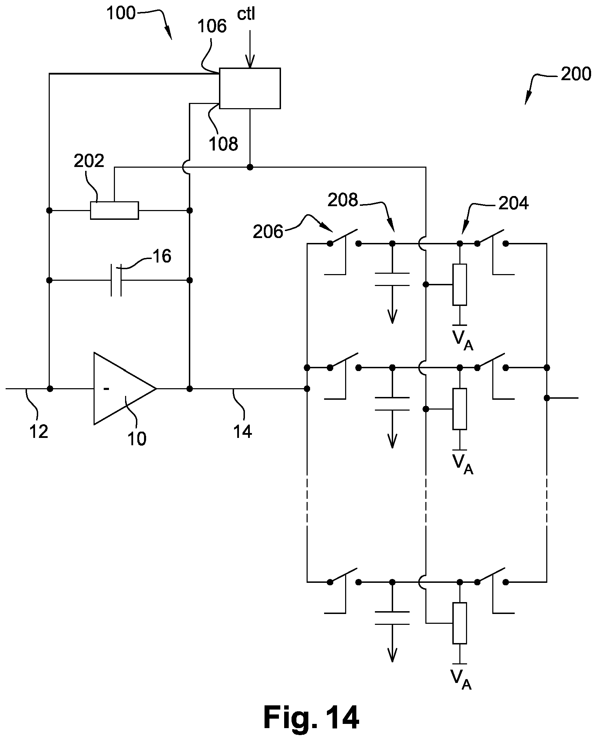

Un autre exemple d'application du dispositif 100 est décrit en lien avec la figure 14 sur laquelle est représenté un circuit électronique 200.

Le circuit électronique 200 comporte l'amplificateur de charges 10 et la capacité d'intégration 16 reliée en parallèle entre l'entrée 12 et la sortie 14 de l'amplificateur 10. Un transistor FET 202 est également relié en parallèle entre l'entrée 12 et la sortie 14 de l'amplificateur 10. Le drain du transistor 202 est relié à la sortie 14 de l'amplificateur 10 et la source du transistor 202 est reliée à l'entrée 12 de l'amplificateur 10. Plusieurs autres transistors FET 204 comportent leur drain relié, via des interrupteurs 206, à la sortie de l'amplificateur 10. Les interrupteurs 206 sont commandés par exemple par un générateur de phases, comme décrit par exemple dans le document WO 2013/034779 A1. Le potentiel électrique $V_A$ obtenu sur la borne 106 est recopié sur les sources des transistors 204.

Les grilles des transistors 202, 204 sont reliées à la grille du premier transistor 116 du dispositif 100 selon l'un des modes de réalisation précédemment décrits. La borne 106 du dispositif 100 est reliée à l'entrée 12 de l'amplificateur 10 et la borne 108 du dispositif 100 est reliée à la sortie 14 de l'amplificateur. Ainsi, le transistor 202 est relié en parallèle au transistor 116 du dispositif 100. Le ou les transistors 204 sont donc reliés en parallèle du transistor 202 lorsque le ou les interrupteurs 206 sont passants.

Ainsi reliés, les transistors 202, 204 forment un miroir de courant. Il est donc possible de considérer chacun des transistors 202, 204 comme équivalent à une résistance, respectivement appelée $R_{202}$ et $R_{204}$.

Le circuit 200 comporte également des capacités d'intégration 208 reliées en parallèle aux transistors 204. Dans ce circuit 200, on cherche à établir une égalité des constantes de temps $R_{202}.C_{16} = R_{204}.C_{208}$ avec $C_{16}$ la valeur de la capacité d'intégration 16 et $C_{208}$ la valeur totale de la ou des capacités d'intégration 208 reliées à l'amplificateur de charges 10, avec $C_{208} = m.C_{16}$ et m nombre entier positif non nul. L'obtention de la relation $R_{202} = m.R_{204}$ est donc recherchée. Cela est possible en contrôlant les transistors 202 et 204 par la grille du premier transistor 116 du dispositif 100 qui pilote alors les valeurs des résistances équivalents $R_{202}$ et $R_{204}$. Ce rapport de résistances m = $R_{202}/R_{204}$ est conservé quel que soit le rapport de multiplication K du dispositif 100 qui déterminé par un signal de commande ctl. Le signal de commande ctl est par exemple un signal numérique de N bits appliqué à chacun des grilles de transistors de commande des miroirs, tels que le transistor 146 du miroir de courant 120 représenté sur la figure 9.

## Revendications

**1.** Dispositif électronique (100) comportant au moins :

- une résistance de référence (105, 140, 142) ;
- deux premières bornes (102, 104) entre lesquelles la résistance de référence (105, 140, 142) est reliée, et deux deuxièmes bornes (106, 108) entre lesquelles une valeur modifiée de l'impédance de la résistance de référence (105, 140 ,142) est destinée à être obtenue ;
- un premier circuit (110, 112) configuré pour appliquer entre les deux deuxièmes bornes (106, 108) une tension égale à celle se trouvant entre les deux premières bornes (102, 104) ;
- un deuxième circuit (114, 120, 126, 134) configuré pour faire circuler entre les deux deuxièmes bornes (106, 108) un deuxième courant dont la valeur i1 correspond à une fraction de la valeur i0 d'un premier courant destiné à circuler dans la résistance de référence (105, 140, 142) entre les deux premières bornes (102, 104), tels que leurs valeurs respectent la relation (il / i0) < 1 ;

dans lequel le deuxième circuit (114, 120, 126, 134) comporte au moins :

- un premier transistor FET (116) dont la source et le drain sont chacun reliés à l'une des deux deuxièmes bornes (106, 108) et dont la grille est configurée pour recevoir un potentiel électrique issu du deuxième circuit (114, 120, 126, 134) et dont la valeur dépend de celle du premier courant ;
- un premier miroir de courant (114) comprenant au moins le premier transistor FET (116) et un deuxième transistor FET (118) ;

- un deuxième miroir de courant (120) comprenant au moins des troisième et quatrième transistors FET (122, 124) de type différent de celui des premier et deuxièmes transistors FET (116, 118) ;

dans lequel les premier et deuxième transistors FET (116, 118) ont des canaux de dimensions différentes l'un par rapport à l'autre et/ou les troisième et quatrième transistors FET (122, 124) ont des canaux de dimensions différentes l'un par rapport à l'autre ;

dans lequel le premier circuit (110, 112) comporte un premier amplificateur opérationnel (110) monté en comparateur ou en suiveur, couplé entre l'une des deux premières bornes (102), l'une des deux deuxièmes bornes (106), et le deuxième circuit (114, 120), et configuré pour recopier le potentiel électrique de ladite une des deux premières bornes (102) sur ladite une des deux deuxièmes bornes (106) ;

et dans lequel le premier circuit (112) comporte en outre un deuxième amplificateur opérationnel (112) monté en comparateur ou en suiveur, couplé entre l'autre des deux deuxièmes bornes (108) et l'autre des deux premières bornes (104) et configuré pour recopier le potentiel électrique de ladite autre des deux premières bornes (104) sur ladite autre des deux deuxièmes bornes (108), ou , pour le cas du premier amplificateur opérationnel monté en comparateur, dans lequel l'autre des deux premières bornes (104) est reliée directement à l'autre des deux deuxièmes bornes (108).

2. Dispositif (100) selon la revendication 1, dans lequel :

- le drain du quatrième transistor FET (124) est relié à l'une des deux premières bornes (102) ;
- le drain du troisième transistor FET (122) est relié au drain du deuxième transistor FET (118) ;
- la source du deuxième transistor FET (118) est reliée à l'autre des deux premières bornes (104).

3. Dispositif (100) selon la revendication 2, dans lequel le deuxième circuit (114, 120, 126, 134) comporte en outre au moins un troisième miroir de courant (126, 134) interposé entre le drain du troisième transistor FET (122) et le drain du deuxième transistor FET (118).

4. Dispositif (100) selon l'une des revendications précédentes, dans lequel le premier amplificateur opérationnel (110) comprend une première entrée reliée à ladite une des deux premières bornes (102), une deuxième entrée reliée à ladite une des deux deuxièmes bornes (106), et une sortie reliée au deuxième circuit (114, 120).

5. Dispositif (100) selon l'une des revendications précédentes, dans lequel :

- la sortie du premier amplificateur opérationnel (110) est reliée aux sources des troisième et quatrième transistors FET (122, 124), les grilles des troisième et quatrième transistors FET (122, 124) sont reliées au drain du quatrième transistor FET (124), et la première entrée du premier amplificateur opérationnel (110) correspond à une entrée inverseuse, ou
- la sortie du premier amplificateur opérationnel (110) est reliée aux grilles des troisième et quatrième transistors FET (122, 124), les sources des troisième et quatrième transistors FET (122, 124) sont configurées pour recevoir un potentiel électrique de référence, et la première entrée du premier amplificateur opérationnel (110) correspond à une entrée non inverseuse.

6. Dispositif (100) selon l'une des revendications précédentes, dans lequel le deuxième amplificateur opérationnel (112) comprend une entrée reliée à ladite autre des deux deuxièmes bornes (108) et une sortie reliée à ladite autre des deux premières bornes (104).

7. Dispositif (100) selon l'une des revendications précédentes, comportant en outre, lorsque le deuxième circuit (114, 120, 126, 134) comporte un nombre n de miroirs de courant (114, 120, 126), avec n nombre entier impair supérieur ou égal à 3, au moins un troisième amplificateur opérationnel (132) interposé entre la sortie du premier amplificateur opérationnel (110) et le deuxième miroir de courant (120).

8. Dispositif (100) selon l'une des revendications précédentes, comportant en outre plusieurs impédances de référence (105, 140, 142) de valeurs différentes, et un troisième circuit configuré pour relier au moins l'une des impédances de référence (105, 140, 142) entre les deux premières bornes (102, 104).

9. Dispositif (100) selon l'une des revendications précédentes, comportant un quatrième circuit configuré pour modifier le rapport des dimensions des canaux des transistors d'au moins un des miroirs de courant (114, 120, 126, 134).

10. Dispositif (100) selon l'une des revendications précédentes, dans lequel la résistance de référence comporte en outre au moins deux deuxièmes résistances (140, 142) formant un pont diviseur de tension et une première résistance (105) reliée en parallèle à l'une des deux deuxièmes résistances (140) du pont diviseur de tension.

11. Circuit électronique (300) comportant au moins :

   - un amplificateur de charges (10) ;
   - une capacité d'intégration (16) reliée en parallèle de l'amplificateur de charges (10), entre une entrée (12) et une sortie (14) de l'amplificateur de charges (10);
   - un dispositif (100) selon l'une des revendications précédentes relié en parallèle de l'amplificateur de charges (10), les deuxièmes bornes (106, 108) du dispositif (100) étant reliées à l'entrée (12) et la sortie (14) de l'amplificateur de charges (10).

12. Circuit électronique (200) comportant au moins :

   - un amplificateur de charges (10) ;
   - une première capacité d'intégration (16) reliée en parallèle à l'amplificateur de charges (10), entre une entrée (12) et une sortie (14) de l'amplificateur de charges (10) ;
   - un cinquième transistor FET (202) relié en parallèle de l'amplificateur de charges (10), les source et drain du cinquième transistor FET (202) étant reliés à l'entrée (12) et la sortie (14) de l'amplificateur de charges (10) ;
   - plusieurs sixièmes transistors FET (204) comportant chacun leur drain relié à la sortie (14) de l'amplificateur de charges (10) par l'intermédiaire d'un interrupteur (206) ;
   - plusieurs deuxièmes capacités d'intégration (208) chacune reliée en parallèle à l'un des sixièmes transistors (204) ;
   - au moins un dispositif électronique (100) selon l'une des revendications 1 à 10 et dans lequel le deuxième circuit (114, 120, 126, 134) comporte au moins un premier transistor FET (116) dont la source et le drain sont chacun reliés à l'une des deux deuxièmes bornes (106, 108) et dont la grille est configurée pour recevoir un potentiel électrique issu du deuxième circuit (114, 120, 126, 134) et dont la valeur dépend de celle du premier courant ;

   et dans lequel les cinquième et sixièmes transistors FET (202, 204) sont reliés à la grille du premier transistor FET (116).

## Patentansprüche

1. Elektronische Vorrichtung (100), umfassend wenigstens:

   - einen Referenzwiderstand (105, 140, 142);
   - zwei erste Anschlüsse (102, 104), zwischen denen der Referenzwiderstand (105, 140, 142) angeschlossen ist, und zwei zweite Anschlüsse (106, 108), zwischen denen ein modifizierter Wert der Impedanz des Referenzwiderstands (105, 140, 142) erhalten werden soll;
   - eine erste Schaltung (110, 112), die dazu ausgebildet ist, zwischen den beiden Anschlüssen (106, 108) eine Spannung anzulegen, die derjenigen zwischen den beiden ersten Anschlüssen (102, 104) entspricht;
   - eine zweite Schaltung (114, 120, 126, 134), die dazu ausgebildet ist, zwischen den beiden Anschlüssen (106, 108) einen zweiten Strom fließen zu lassen, dessen Wert i1 einem Bruchteil des Wertes i0 eines ersten Stroms entspricht, der dazu bestimmt ist, in dem Referenzwiderstand (105, 140, 142) zwischen den beiden ersten Anschlüssen (102, 104) zu fließen, so dass ihre Werte dem Verhältnis (i1/i0) < 1 entsprechen;

   wobei die zweite Schaltung (114, 120, 126, 134) wenigstens umfasst:

   - einen ersten FET-Transistor (116), dessen Source und Drain jeweils mit einem der beiden Anschlüsse (106, 108) verbunden sind und dessen Gate dazu ausgebildet ist, ein elektrisches Potential von der zweiten Schaltung (114, 120, 126, 134) zu empfangen und dessen Wert von dem des ersten Stroms abhängt;
   - einen ersten Stromspiegel (114), der wenigstens den ersten FET-Transistor (116) und einen zweiten FET-Transistor (118) umfasst;
   - einen zweiten Stromspiegel (120), der wenigstens einen dritten und vierten FET-Transistor (122, 124) eines anderen Typs als der erste und zweite FET-Transistor (116, 118) umfasst;
   wobei der erste und der zweite FET-Transistor (116, 118) Kanäle mit voneinander verschiedenen Abmessungen aufweisen und/oder der dritte und der vierte FET-Transistor (122, 124) Kanäle mit voneinander verschiedenen Abmessungen aufweisen;

wobei die erste Schaltung (110, 112) einen ersten Operationsverstärker (110) umfasst, der als Komparator oder Nachläufer angebracht ist, der zwischen einem der beiden ersten Anschlüsse (102), einem der beiden zweiten Anschlüsse (106) und der zweiten Schaltung (114, 120) gekoppelt ist, und dazu ausgebildet ist, das elektrische Potential des einen der beiden ersten Anschlüsse (102) auf den einen der beiden zweiten Anschlüsse (106) abzubilden;

und wobei die erste Schaltung (112) ferner einen zweiten Operationsverstärker (112) umfasst, der als Komparator oder Nachläufer angebracht ist, der zwischen dem anderen der beiden zweiten Anschlüsse (108) und dem anderen der beiden ersten Anschlüsse (104) gekoppelt ist und dazu ausgebildet ist, das elektrische Potential des anderen der beiden ersten Anschlüsse (104) auf den anderen der beiden zweiten Anschlüsse (108) abzubilden oder, für den Fall, dass der erste Operationsverstärker als Komparator aufgebaut ist, wobei der andere der ersten beiden Anschlüsse (104) direkt mit dem anderen der zweiten beiden Anschlüsse (108) verbunden ist.

2. Vorrichtung (100) nach Anspruch 1, wobei:

- der Drain des vierten FET-Transistors (124) mit einem der beiden ersten Anschlüsse (102) verbunden ist;
- der Drain des dritten FET-Transistors (122) mit dem Drain des zweiten FET-Transistors (118) verbunden ist;
- die Source des zweiten FET-Transistors (118) mit dem anderen der beiden ersten Anschlüsse (104) verbunden ist.

3. Vorrichtung (100) nach Anspruch 2, wobei die zweite Schaltung (114, 120, 126, 134) ferner wenigstens einen dritten Stromspiegel (126, 134) umfasst, der zwischen dem Drain des dritten FET-Transistors (122) und dem Drain des zweiten FET-Transistors (118) angeordnet ist.

4. Vorrichtung (100) nach einem der vorhergehenden Ansprüche, wobei der erste Operationsverstärker (110) einen ersten Eingang umfasst, der mit dem einen der beiden ersten Anschlüsse (102) verbunden ist, einen zweiten Eingang, der mit dem einen der beiden zweiten Anschlüsse (106) verbunden ist, und einen Ausgang, der mit der zweiten Schaltung (114, 120) verbunden ist.

5. Vorrichtung (100) nach einem der vorhergehenden Ansprüche, wobei:

- der Ausgang des ersten Operationsverstärkers (110) mit den Sources des dritten und vierten FET-Transistors (122, 124) verbunden ist, die Gates des dritten und vierten FET-Transistors (122, 124) mit dem Drain des vierten FET-Transistors (124) verbunden sind, und der erste Eingang des ersten Operationsverstärkers (110) einem invertierenden Eingang entspricht, oder
- der Ausgang des ersten Operationsverstärkers (110) mit den Gates des dritten und vierten FET-Transistors (122, 124) verbunden ist, die Sources des dritten und vierten FET-Transistors (122, 124) dazu ausgebildet sind, ein elektrisches Referenzpotential zu empfangen, und der erste Eingang des ersten Operationsverstärkers (110) einem nicht-invertierenden Eingang entspricht.

6. Vorrichtung (100) nach einem der vorhergehenden Ansprüche, wobei der zweite Operationsverstärker (112) einen mit dem anderen der beiden zweiten Anschlüsse (108) verbundenen Eingang und einen mit dem anderen der beiden ersten Anschlüsse (104) verbundenen Ausgang aufweist.

7. Vorrichtung (100) nach einem der vorhergehenden Ansprüche, ferner umfassend, wenn die zweite Schaltung (114, 120, 126, 134) eine Anzahl n von Stromspiegeln (114, 120, 126) umfasst, wobei n eine ungerade ganze Zahl größer gleich 3 ist, wenigstens einen dritten Operationsverstärker (132), der zwischen dem Ausgang des ersten Operationsverstärkers (110) und dem zweiten Stromspiegel (120) angeordnet ist.

8. Vorrichtung (100) nach einem der vorhergehenden Ansprüche, ferner umfassend mehrere Referenzimpedanzen (105, 140, 142) mit unterschiedlichen Werten und eine dritte Schaltung, die dazu ausgebildet ist, wenigstens einen der Referenzimpedanzen (105, 140, 142) zwischen den ersten beiden Anschlüssen (102, 104) zu verbinden.

9. Vorrichtung (100) nach einem der vorhergehenden Ansprüche, die eine vierte Schaltung umfasst, die dazu ausgebildet ist, das Verhältnis der Abmessungen der Transistorkanäle wenigstens eines der Stromspiegel (114, 120, 126, 134) zu ändern.

10. Vorrichtung (100) nach einem der vorhergehenden Ansprüche für den Fall, wobei der Referenzwiderstand ferner wenigstens zwei zweite Widerstände (140, 142) umfasst, die eine Spannungsteilerbrücke bilden, und einen ersten Widerstand (105) umfasst, der parallel zu einem der beiden zweiten Widerstände (140) der Spannungsteilerbrücke angebracht ist.

11. Elektronische Schaltung (300), umfassend wenigstens:

- einen Ladungsverstärker (10);
- eine Integrationskapazität (16), die parallel zu dem Ladungsverstärker (10) zwischen einem Eingang (12) und einem Ausgang (14) des Ladungsverstärkers (10) angebracht ist;
- eine Vorrichtung (100) nach einem der vorhergehenden Ansprüche, die parallel zu dem Ladungsverstärker (10) verbunden ist, wobei die zweiten Anschlüsse (106, 108) der Vorrichtung (100) mit dem Eingang (12) und dem Ausgang (14) des Ladungsverstärkers (10) verbunden sind.

12. Elektronische Schaltung (200), umfassend wenigstens:

- einen Ladungsverstärker (10);
- einen ersten Integrationskondensator (16), der parallel zu dem Ladungsverstärker (10) zwischen einem Eingang (12) und einem Ausgang (14) des Ladungsverstärkers (10) verbunden ist;
- einen fünften FET-Transistor (202), der parallel zu dem Ladungsverstärker (10) angebracht ist, wobei die Source und der Drain des fünften FET-Transistors (202) mit dem Eingang (12) und dem Ausgang (14) des Ladungsverstärkers (10) verbunden sind;
- mehrere sechste FET-Transistoren (204), umfassend jeweils ihren Drain, der über einen Schalter (206) mit dem Ausgang (14) des Ladungsverstärkers (10) verbunden ist;
- mehrere zweite Integrationskapazitäten (208), die jeweils parallel zu einem der sechsten Transistoren (204) angebracht sind;
- wenigstens eine elektronische Vorrichtung (100) nach einem der Ansprüche 1 bis 10, wobei die zweite Schaltung (114, 120, 126, 134) wenigstens einen ersten FET-Transistor (116) umfasst, dessen Source und Drain jeweils mit einem der beiden zweiten Anschlüsse (106, 108) verbunden sind und dessen Gate dazu ausgebildet ist, ein elektrisches Potential aus der zweiten Schaltung (114, 120, 126, 134) aufzunehmen und dessen Wert von dem des ersten Stroms abhängt;

und wobei der fünfte und sechste FET-Transistor (202, 204) mit dem Gate des ersten FET-Transistors (116) verbunden sind.

**Claims**

1. Electronic device (100) including at least:

- a reference resistor (105, 140, 142);
- two first terminals (102, 104) between which the reference resistor (105, 140, 142) is connected, and two second terminals (106, 108) between which a modified impedance value of the reference resistor (105, 140, 142) is obtained;
- a first circuit (110, 112) configured to apply between the two second terminals (106, 108) a voltage substantially equal to that between the two first terminals (102, 104);
- a second circuit (114, 120, 126, 134) configured to flow between the two second terminals (106, 108) a second current the value i1 of which corresponds to a fraction of the value i0 of a first current intended to flow in the reference resistor (105, 140, 142) between the two first terminals (102, 104) such that their values verify the relationship (i1/i0) < 1;

wherein the second circuit (114, 120, 126, 134) includes at least:

- one first FET transistor (116) the source and drain of which are each connected to one of the two second terminals (106, 108) and the gate of which is configured to receive an electric potential from the second circuit (114, 120, 126, 134) and the value of which depends on that of the first current;
- a first current mirror (114) comprising at least the first FET transistor (116) and a second FET transistor (118) ;
- a second current mirror (120) comprising at least third and fourth FET transistors (122, 124) of a different type from that of the first and second FET transistors (116, 118);

wherein the first and second FET transistors (116, 118) have channels with dimensions different from each other and/or the third and fourth FET transistors (122, 124) have channels with dimensions different from each other;

wherein the first circuit (110, 112) includes one first operational amplifier (110) connected as a comparator or a follower, coupled between one of the two first terminals (102), one of the two second terminals (106), and the second circuit (114, 120), and configured to recopy the electric potential of said one of the two first terminals (102) on said one of the two second terminals (106);

and wherein the first circuit (112) further includes a second operational amplifier (112) connected as a comparator or a follower, coupled between the other of the two second terminals (108) and the other of the two first terminals (104) and configured to recopy the electric potential of said other of the two first terminals (104) on said other of the two second terminals (108), or, when the first operational amplifier is connected as a comparator, the other of the two first terminals (104) is directly connected to the other of the two second terminals (108).

2.  Device (100) according to claim 1, wherein:

    - the drain of the fourth FET transistor (124) is connected to one of the two first terminals (102);
    - the drain of the third FET transistor (122) is connected to the drain of the second FET transistor (118);
    - the source of the second FET transistor (118) is connected to the other of the two first terminals (104).

3.  Device (100) according to claim 2, wherein the second circuit (114, 120, 126, 134) further includes at least one third current mirror (126, 134) interposed between the drain of the third FET transistor (122) and the drain of the second FET transistor (118).

4.  Device (100) according to one of the preceding claims, wherein the first operational amplifier (110) comprises a first input connected to said one of the two first terminals (102), a second input connected to said one of the two second terminals (106), and an output connected to the second circuit (114, 120).

5.  Device (100) according to one of the preceding claims, wherein:

    - the output of the first operational amplifier (110) is connected to the sources of the third and fourth FET transistors (122, 124), the gates of the third and fourth FET transistors (122, 124) are connected to the drain of the fourth FET transistor (124), and the first input of the first operational amplifier (110) corresponds to an inverting input, or
    - the output of the first operational amplifier (110) is connected to the gates of the third and fourth FET transistors (122, 124), the sources of the third and fourth FET transistors (122, 124) are configured to receive a reference electric potential, and the first input of the first operational amplifier (110) corresponds to a non-inverting input.

6.  Device (100) according to one of the preceding claims, wherein the second operational amplifier (112) comprises an input connected to said other of the two second terminals (108) and an output connected to said other of the two first terminals (104).

7.  Device (100) according to one of the preceding claims, further including, when the second circuit (114, 120, 126, 134) includes a number n of current mirrors (114, 120, 126), with n an odd integer higher than or equal to 3, at least one third operational amplifier (132) interposed between the output of the first operational amplifier (110) and the second current mirror (120).

8.  Device (100) according to one of the preceding claims, further including several reference impedances (105, 140, 142) with different values, and a third circuit configured to connect at least one of the reference impedances (105, 140, 142) between the two first terminals (102, 104).

9.  Device (100) according to one of the preceding claims, including a fourth circuit configured to modify the dimension ratio of the transistor channels of at least one of the current mirrors (114, 120, 126, 134).

10. Device (100) according to one of the preceding claims, wherein the reference resistor further includes at least two second resistors (140, 142) forming a voltage dividing bridge and a first resistor (105) connected in parallel to one of the two second resistors (140) of the voltage dividing bridge.

**11.** Electronic circuit (300) including at least:

   - a charge amplifier (10);
   - an integration capacitance (16) connected in parallel to the charge amplifier (10), between an input (12) and an output (14) of the charge amplifier (10);
   - a device (100) according to one of the preceding claims connected in parallel to the charge amplifier (10), the second terminals (106, 108) of the device (100) being connected to the input (12) and the output (14) of the charge amplifier (10).

**12.** Electronic circuit (200) including at least:

   - a charge amplifier (10);
   - a first integration capacitance (16) connected in parallel to the charge amplifier (10), between an input (12) and an output (14) of the charge amplifier (10);
   - a fifth FET transistor (202) connected in parallel to the charge amplifier (10), the source and drain of the fifth FET transistor (202) being connected to the input (12) and the output (14) of the charge amplifier (10);
   - several sixth FET transistors (204) each having their drain connected to the output (14) of the charge amplifier (10) through a switch (206);
   - several second integration capacitances (208) each connected in parallel to one of the sixth transistors (204);
   - at least one electronic device (100) according to one of claims 1 to 10 and wherein the second circuit (114, 120, 126, 134) includes at least one first FET transistor (116) the source and drain of which are each connected to one of the two second terminals (106, 108) and the gate of which is configured to receive an electric potential from the second circuit (114, 120, 126, 134) and the value of which depends on that of the first current;

and wherein the fifth and sixth FET transistors (202, 204) are connected to the gate of the first FET transistor (116).

Fig. 1

Fig. 2

Fig. 3

Fig. 4

Fig. 5

Fig. 6

Fig. 7

Fig. 8

**Fig. 9**

**Fig. 10**

Fig. 11

mag    WM(IMP_AC)

3.0e9

2.5

2.0

1.5

60

1.0

0.5

0.0

1e+03        1e+04        1e+05        1e+06
                                          Hz

**Fig. 12**

IMP_EXT_1:13   IMP_EXT_2:13   IMP_EXT_3:13

1.6e9

1.4

1.2     64    62

1.0

0.8         66

0.6

0.4

0.2

0.0

0.2    0.3    0.4    0.5    0.6    0.7    0.8

**Fig. 13**

**Fig. 14**

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 6897528 B2
- US 20130069716 A1
- US 20170070209 A
- US 20160020734 A
- WO 2013034779 A1

**Littérature non-brevet citée dans la description**

- **A. TAJALLI et al.** Implementing ultra-high-value floating tunable CMOS resistors. *Electronics Letters,* 2008, vol. 44 (5), 349-350